Europäisches Patentamt

European Patent Office

Office européen des brevets

(11) Numéro de publication : **0 467 450 B1**

(12) **FASCICULE DE BREVET EUROPEEN**

(45) Date de publication du fascicule du brevet :
08.11.95 Bulletin 95/45

(51) Int. Cl.⁶ : **H03F 3/19, H03F 3/343**

(21) Numéro de dépôt : **91201770.4**

(22) Date de dépôt : **08.07.91**

(54) **Amplificateur large bande présentant des sorties séparées.**

(30) Priorité : **17.07.90 FR 9009084**

(43) Date de publication de la demande :
**22.01.92 Bulletin 92/04**

(45) Mention de la délivrance du brevet :
**08.11.95 Bulletin 95/45**

(84) Etats contractants désignés :
**DE FR GB IT NL**

(56) Documents cités :
**FR-A- 2 103 281
US-A- 3 651 347
US-A- 4 240 041
US-A- 4 525 682
PATENT ABSTRACTS OF JAPAN, vol. 2, no.
137 (E-78)[8552], 15 novembre 1978; & JP-A-53
105 347 (NIPPON DENKI K.K.) 13-09-1978
ELECTRONIC DESIGN, vol. 33, no. 15, juin
1985, pages 141-144, Hasbrouck Heights, New
Jersey, US; T. DeLURIO et al.: "Monolithic
amplifier makes the leap into uhf telecomm
territory"**

(73) Titulaire : **PHILIPS COMPOSANTS
4, rue du Port aux Vins
F-92150 Suresnes (FR)**
(84) **FR**
Titulaire : **Philips Electronics N.V.
Groenewoudseweg 1
NL-5621 BA Eindhoven (NL)**
(84) **DE GB IT NL**

(72) Inventeur : **Chevallier, Gilles, Société Civile
S.P.I.D.
156, Boulevard Haussmann
F-75008 Paris (FR)**

(74) Mandataire : **Charpail, François et al
Société Civile S.P.I.D.
156, Boulevard Haussmann
F-75008 Paris (FR)**

Jouve, 18, rue Saint-Denis, 75001 PARIS

## Description

La présente invention concerne un amplificateur à large bande comportant une sortie directe à laquelle est connecté un étage décaleur de niveau présentant au moins une sortie décalée en niveau et présentant au moins un premier transistor suiveur en série avec au moins un élément décaleur de niveau, ledit premier transistor comportant une première résistance disposée entre sa base et une source de tension d'alimentation, et un circuit de contre-réaction à partir d'au moins une sortie décalée en niveau.

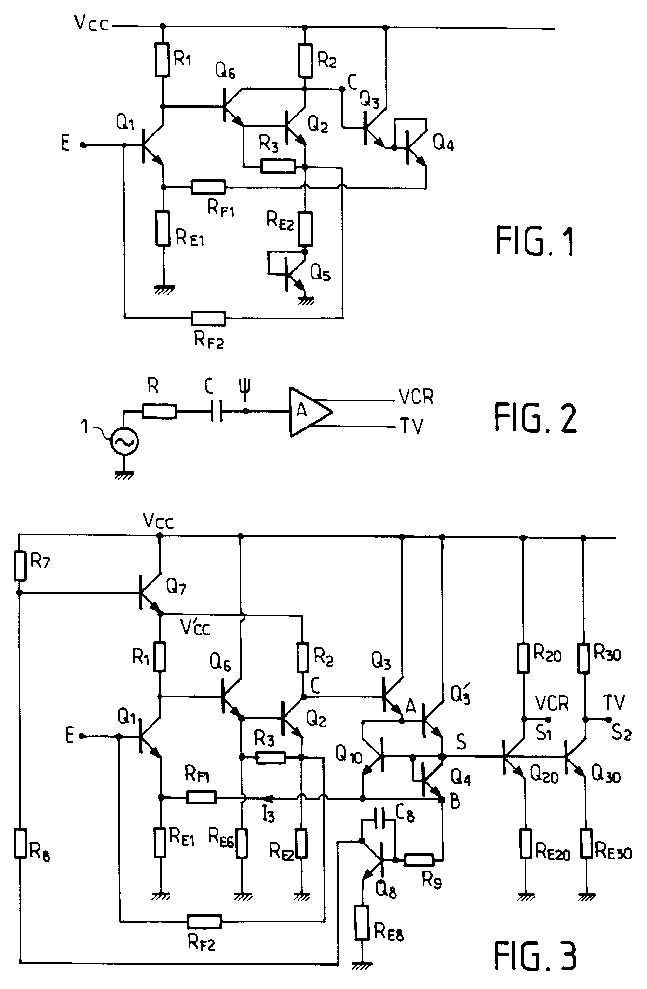

Un tel amplificateur est connu de l'article "A 4-Terminal Wide-Band Monolithic Amplifier" de Robert G. MEYER et Robert A. BLAUSCHILD publié dans IEEE Journal of Solid State Circuits Vol SC. 16 n°6 décembre 1981, pages 634 à 638, en particulier figures 2 et 8.

Un tel amplificateur présente l'avantage d'une large bande passante ainsi que d'un niveau de bruit peu élevé et de valeurs favorables pour les impédances d'entrée et de sortie.

L'invention propose d'améliorer les caractéristiques d'un amplificateur présentant des sorties séparées de manière à obtenir une séparation élevée entre les sorties, par exemple pour réaliser un mélangeur-séparateur présentant une sortie téléviseur et une sortie magnétoscope.

L'idée de base de l'invention consiste à mettre en oeuvre un amplificateur du type précité, lequel présente intrinsèquement des caractéristiques intéressantes, et d'améliorer les caractéristiques du décaleur de tension de la boucle principale de contre-réaction, en vue d'obtenir une isolation élevée entre des sorties séparées qui leur sont connectées.

Un amplificateur selon l'invention est ainsi caractérisé en ce qu'il comporte au moins un deuxième et un troisième transistor de sortie séparée dont la base est connectée à une dite sortie décalée en niveau et qui sont agencés de manière que leur collecteur constitue respectivement une première et une deuxième sortie séparée, en ce que l'étage décaleur de niveau comporte un quatrième transistor suiveur en cascade entre le premier transistor suiveur et l'élément décaleur de niveau et en ce qu'il comporte un cinquième transistor formant miroir de courant avec ledit élément décaleur de niveau et dont le trajet de courant principal est connecté en série entre le trajet de courant principal du premier transistor suiveur et une borne de l'élément décaleur de niveau non connectée au quatrième transistor suiveur.

Le miroir de courant permet de diminuer l'impédance de sortie du décaleur et d'améliorer l'isolation entre les sorties séparées sans augmenter le niveau de bruit.

Selon un mode de réalisation avantageux, l'amplificateur comporte un sixième transistor dont la base constitue une entrée de l'amplificateur et dont le collecteur est connecté à la base d'un septième transistor constituant un étage Darlington avec un huitième transistor aval, ladite sortie directe étant prise sur le collecteur du huitième transistor, qui est connecté à la base du premier transistor suiveur.

Ladite contre-réaction peut alors comporter une deuxième résistance connectée entre ladite sortie décalée en niveau et l'émetteur du sixième transistor, lequel présente une troisième résistance d'émetteur. Une quatrième résistance peut être connectée entre l'émetteur du huitième transistor et la base du sixième transistor, de manière à constituer une contre-réaction auxiliaire permettant de définir l'impédance d'entrée sans introduire de résistance d'entrée de faible valeur, qui introduirait du bruit.

Une limitation du courant dans la contre-réaction principale peut être obtenue grâce à un neuvième transistor dont la base est connectée à ladite sortie décalée en niveau et dont le collecteur est relié à travers une cinquième résistance à la base d'un dixième transistor dont le trajet de courant principal est connecté entre ladite source de tension d'alimentation et d'une part une sixième résistance de polarisation du collecteur du sixième transistor et d'autre part la première résistance.

Un décalage de quatre tensions base-émetteur peut être obtenu en cascadant un onzième transistor suiveur entre le premier et le quatrième transistor suiveur, un douzième transistor formant miroir de courant avec l'élément décaleur de niveau, son trajet de courant principal étant connecté en série entre le trajet de courant principal du onzième transistor et la borne de l'élément décaleur de niveau non connectée au quatrième transistor suiveur.

Une première source de courant peut être connectée à la borne commune au quatrième transistor suiveur et à l'élément décaleur de niveau, et au moins une deuxième source de courant peut être connectée à la base d'au moins un des premier et quatrième transistors. Une au moins desdites sources de courant peut être constituée par une septième résistance.

L'invention sera mieux comprise à la lecture de la description qui va suivre, donnée à titre d'exemple non limitatif, en liaison avec les dessins qui représentent :
- la figure 1, un amplificateur selon l'art antérieur précité,
- la figure 2, un diagramme d'un mélangeur-séparateur pour pour récepteur de télévision,
- la figure 3, un amplificateur selon un mode préféré de réalisation de l'invention,
- la figure 4 et la figure 5, deux variantes selon l'invention du circuit décaleur.

Selon la figure 1, un amplificateur à large bande tel que décrit dans la publication précitée de MEYER et BLAUSCHILD comporte un transistor $Q_1$ dont la base constitue l'entrée E de l'amplificateur, et dont le collecteur, relié à une source de tension d'alimentation $V_{cc}$, est connecté à la base d'un transistor $Q_6$ constituant le transistor amont d'un étage Darlington dont le transistor aval est un transistor $Q_2$. Une résistance $R_3$ est connectée entre les émetteurs des transistors $Q_2$ et $Q_6$. Les collecteurs interconnectés des transistors $Q_2$ et $Q_6$ constituent une sortie directe C de l'amplificateur. Une résistance $R_2$ peut les relier à la source de tension d'alimentation $V_{cc}$. Une boucle de contre-réaction principale, qui définit le gain de l'amplificateur comporte un circuit décaleur à deux niveaux, à savoir un premier transistor $Q_3$ monté en émetteur suiveur à partir de la sortie C, son collecteur étant référencé à la source de tension d'alimentation $V_{cc}$, et en cascade avec une diode en direct $Q_4$, ici réalisée à partir d'un transistor de même type que $Q_3$ et dont la base et le collecteur sont interconnectés. Une résistance de contre-réaction $R_{F1}$ est connectée en série entre la cathode (émetteur) de la diode $Q_4$ (point B) et l'émetteur du transistor $Q_1$, lequel est relié au pôle de mode commun (masse) à travers une résistance $R_{E1}$.

Le gain de l'amplificateur a alors pour valeur :

$$\frac{R_{F1} + R_{E1}}{2\,R_{E1}}$$

L'étage Darlington permet d'obtenir un gain élevé en boucle ouverte. Une contre-réaction auxiliaire, qui influe favorablement sur les impédances d'entrée et de sortie comporte une résistance $R_{F2}$ connectée entre l'émetteur du transistor $Q_2$ et la base du transistor $Q_1$ (entrée E). La résistance $R_{F2}$ permet de polariser en continu (DC) la base du transistor $Q_1$.

Un tel amplificateur, pourvu de sa boucle de contre-réaction principale, et éventuellement de la contre-réaction auxiliaire, présente une large bande passante et un niveau de bruit relativement faible, et convient de ce fait à l'amplification de signaux faibles, tels que les signaux d'antenne.

La figure 2 représente un schéma d'un séparateur-mélangeur comportant un amplificateur A recevant à son entrée des signaux d'antenne $\psi$ et présentant deux sorties séparées, l'une (TV) pour alimenter un récepteur de télévision, et l'autre (VCR) pour alimenter un magnétoscope. Ces deux sorties doivent présenter l'une par rapport à l'autre et vis à vis de l'antenne une bonne isolation.

Selon la figure 3, les éléments remplissant la même fonction présentent la même référence que sur la figure 1. Le décaleur de sortie présente trois niveaux de manière à décaler de trois tensions base-émetteur, deux transistors $Q_3$ et $Q'_3$ étant cascadés en émetteur suiveur avec un transistor $Q_4$ monté en diode. L'émetteur du transistor $Q'_3$ constitue une sortie S décalée en niveau de deux tensions base-émetteur, et à partir de laquelle sont obtenues deux sorties séparées $S_1$ et $S_2$ de la manière suivante. Deux transistors $Q_{20}$ et $Q_{30}$ ont leur collecteur relié à la source de tension d'alimentation $V_{cc}$ à travers des résistances respectivement $R_{20}$ et $R_{30}$, leur émetteur relié au pôle de mode commun à travers des résistances respectivement $R_{E20}$ et $R_{E30}$, et leur base connectée à la sortie S. Les collecteurs des transistors $Q_{20}$ et $Q_{30}$ constituant les sorties séparées respectivement $S_1$ (par exemple sortie VCR) et $S_2$ (par exemple sortie TV).

L'isolation des sorties $S_1$ et $S_2$ avec l'entrée de l'amplificateur ou bien entre elles n'est pas parfaite. Aux fréquences élevées, la capacité collecteur-base des transistors $Q_{20}$ et $Q_{30}$ a pour effet de réinjecter une partie des signaux sur la sortie S et d'une sortie sur l'autre.

Pour améliorer cette isolation, il a été constaté qu'il convenait de diminuer la valeur de l'impédance de sortie du décaleur de tension (point B) ainsi qu'au point S et d'augmenter la valeur de son impédance au point A (base du transistor $Q'_3$). Pour ce faire, un transistor $Q_{10}$ a sa base connectée au point S et son trajet de courant principal connecté entre les points A et B, c'est-à-dire en série avec le trajet de courant principal du transistor $Q_3$. Si les transistors $Q_4$ et $Q_{10}$ sont identiques, le courant de sortie I se divise également entre les transistors $Q_{10}$ et $Q_4$. Soient $Z_{B1}$ et $Z_{S1}$ l'impédance de sortie respectivement au point B et au point S en l'absence du transistor $Q_{10}$, et $Z_{B2}$ et $Z_{S2}$ l'impédance de sortie respectivement au point B et au point S avec le transistor $Q_{10}$.

Soit $Z_{A1}$ l'impédance d'entrée au point A en l'absence de transistor $Q_{10}$,
et $Z_{A2}$ l'impédance d'entrée au point A avec le transistor $Q_{10}$.

On a :

$$Z_{B1} \simeq \frac{R_2}{\beta} + 3r_d \qquad Z_{B2} \simeq \frac{R_2}{2\beta} + 3r_d$$

$$Z_{S1} \simeq \frac{R_2}{\beta} + 2r_d \qquad Z_{S2} \simeq 2r_d$$

$$Z_{A1} \simeq R_{F1} + 2r_d \qquad Z_{A2} \simeq 2(R_{F1} + 2r_d)$$

avec

$r_d$ = résistance d'émetteur d'un transistor

$\beta$ = gain en courant du transistor $Q_3$.

Le décalage de niveau (trois tensions base-émetteur d'un transistor) reste à peu de choses près identique (baisse de 18mV).

Le transistor $Q_3$ (traversé par un courant I/2) est alimenté par le transistor $Q_{10}$.

Pour optimiser le circuit, il faut que les résistances dynamiques des diodes soient très faibles vis-à-vis de la valeur de $R_{F1}$. Cette condition est aisément remplie avec le circuit proposé, lequel n'augmente pas la consommation de courant ni le niveau de bruit.

L'adjonction d'un transistor $Q_{10}$ permet d'obtenir une amélioration allant jusqu'à environ 10 dB pour l'isolation entre l'entrée et la sortie de l'amplificateur, c'est-à-dire entre l'antenne et une des sorties $S_1$ ou $S_2$, ainsi qu'entre les deux sorties.

A titre d'exemple, les valeurs des composants peuvent être les suivantes :

$R_1 = 500\ \Omega$ $R_2 = 50\ \Omega$

$R_{F1} = 120\ \Omega$ $R_{F2} = 600\ \Omega$

$R_{E1} = 15\ \Omega$ $R_{E2} = 80\ \Omega$ $R_{E6} = 500\ \Omega$

On va maintenant montrer comment on peut limiter le courant $I_3$ qui traverse la résistance de contre-réaction principale $R_{F1}$.

Soit n le nombre de niveaux du décaleur de tension (pour la figure 3, n = 3).

On a en première approximation :

$$I_3 = \frac{V_{CC} - V_{BE}\left[(1 + \dfrac{R_2}{R_{E2}}) + n - 1\right]}{R_{F1} + R_{E1}(1 + \dfrac{R_2}{R_{E2}})}$$

$I_3$ est très sensible aux variations de $V_{cc}$ et de la température.

Pour que la contre-réaction ait une bonne linéarité et un gain indépendant du décaleur de tension, il faut que la résistance $R_{F1}$ ait une valeur très supérieure à l'impédance $Z_{S2}$ du décaleur soit :

$$R_{F1} \gg \frac{R_2}{2\beta} + 3r_d$$

Comme la valeur de $R_{F1}$ est choisie en fonction d'un certain nombre de paramètres correspondant aux performances exigées du dispositif et comme $I_3$ est sensible aux variations thermiques et à celles de la tension d'alimentation, il est souhaitable de contrôler au moins au premier ordre ses variations de manière à éviter une consommation en courant trop élevée dans des conditions extrêmes.

Pour ce faire, l'idée de base est la constatation que la tension $V_3$ au point B rend essentiellement compte du courant $I_3$. Le contrôle du courant $I_3$ peut être effectué en mesurant la tension $V_3$.

Un transistor $Q_8$ a sa base reliée au point B à travers une résistance $R_9$ de valeur élevée, et son émetteur relié à une source de tension d'alimentation (masse) à travers une résistance $R_{E8}$. Un condensateur d'intégration $C_8$ est connecté entre son collecteur et sa base. Son collecteur est relié à travers une résistance $R_8$ à la base d'un transistor ballast $Q_7$ dont le collecteur est connecté à la source de tension d'alimentation $V_{cc}$, et son émetteur à une borne des résistances $R_1$ et $R_2$. Une résistance $R_7$ est connectée entre le collecteur et la base du transistor $Q_7$, de telle sorte qu'elle forme un pont diviseur avec la résistance $R_8$. La résistance $R_7$ est choisie de manière à ne pas perturber l'amplificateur. Le courant traversant la résistance $R_7$ dépend du courant $I_3$ et la tension $V'_{cc}$ sur l'émetteur du transistor $Q_7$ tend à baisser lorsque le courant $I_3$ tend à augmenter, d'où la régulation obtenue car $I_3$ dépend de $V'_{cc}$ au lieu de $V_{cc}$ avec ce montage.

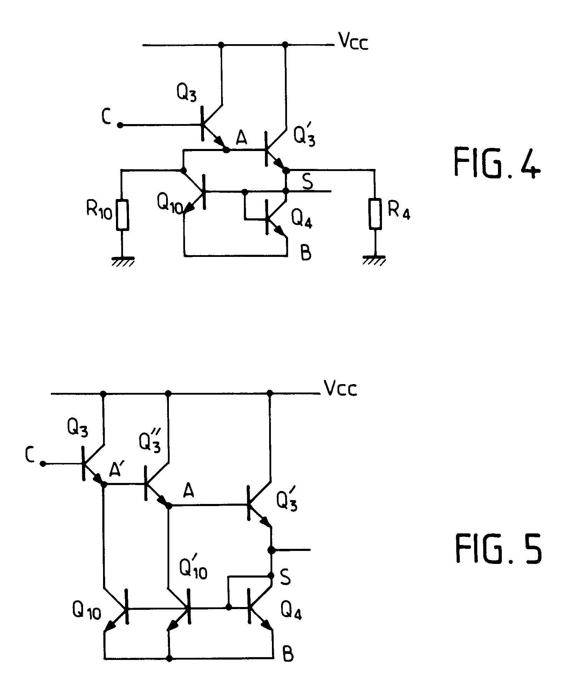

La figure 4 représente un montage dans lequel la linéarité du décaleur de tension a été améliorée par adjonction de sources de courant aux points A et S, celles-ci étant constituées par des résistances respectivement $R_{10}$ et $R_4$.

La figure 5 représente un exemple de réalisation correspondant au cas n = 4. Un transistor suiveur $Q''_3$ est cascadé en série entre les transistors $Q_3$ et $Q'_3$, et un transistor $Q'_{10}$ formant miroir de courant avec la diode $Q_4$ a son trajet de courant principal en série avec celui du transistor $Q''_3$. Ce montage peut permettre de diminuer $I_3$.

L'invention ne se limite pas aux modes de réalisation décrits et représentés. En particulier, les transistors représentés sont du type npn, lesquels se prêtent le mieux à une réalisation intégrée car ils sont plus rapides que leurs homologues pnp, avec lesquels un amplificateur selon l'invention pourrait être réalisé.

## Revendications

1. Amplificateur à large bande comportant une sortie directe à laquelle est connecté un étage décaleur de niveau présentant au moins une sortie décalée en niveau et comportant au moins un premier transistor suiveur en série avec au moins un élément décaleur de niveau, ledit transistor comportant une première résistance disposée entre sa base et une source de tension d'alimentation, et un circuit de contre-réaction à partir d'au moins une sortie décalée en niveau, caractérisé en ce qu'il comporte au moins un deuxième ($Q_{20}$) et un troisième ($Q_{30}$) transistor de sortie séparée dont la base est connectée à une dite sortie décalée en niveau (S) et qui sont agencés de manière que leur collecteur constitue respectivement une première ($S_1$) et une deuxième ($S_2$) sortie séparée, en ce que l'étage décaleur de niveau comporte un quatrième transistor suiveur ($Q'_3$) en cascade entre le premier transistor suiveur ($Q_3$) et l'élément décaleur de niveau ($Q_4$) et en ce qu'il comporte un cinquième transistor ($Q_{10}$) formant miroir de courant avec ledit élément décaleur de niveau et dont le trajet de courant principal est connecté en série entre le trajet de courant principal du premier transistor suiveur ($Q_3$) et une borne de l'élément décaleur de niveau ($Q_4$) non connectée au quatrième transistor suiveur ($Q'_3$).

2. Amplificateur selon la revendication 1, caractérisé en ce que l'élément décaleur de niveau est un transistor monté en diode.

3. Amplificateur selon une des revendication 1 ou 2caractérisé en ce qu'il comporte un sixième transistor ($Q_1$) dont la base constitue une entrée de l'amplificateur et dont le collecteur est connecté à la base d'un septième transistor ($Q_6$) constituant un étage Darlington avec un huitième transistor ($Q_2$) aval, ladite sortie directe (C) étant prise sur le collecteur du huitième transistor ($Q_2$) qui est connecté à la base du premier transistor suiveur ($Q_3$).

4. Amplificateur selon la revendication 3, caractérisé en ce que ladite contre-réaction comporte une deuxième résistance ($R_{F1}$) connectée entre ladite sortie décalée en niveau (B) et l'émetteur du sixième transistor ($Q_1$), lequel présente une troisième résistance d'émetteur ($R_{E1}$).

5. Amplificateur selon une des revendication 3 ou 4 caractérisé en ce qu'il comporte une quatrième résistance ($R_{F2}$) connectée entre l'émetteur du huitième transistor ($Q_2$) et la base du sixième ($Q_1$) transistor.

6. Amplificateur selon une des revendications 3 à 5 caractérisé en ce qu'il comporte un neuvième transistor ($Q_8$) dont la base est connectée à ladite sortie décalée en niveau (B) et dont le collecteur est relié à travers une cinquième résistance ($R_8$) à la base d'un dixième transistor ($Q_7$) dont le trajet de courant principal est connecté entre ladite source de tension d'alimentation, et d'une part une sixième ($R_1$) résistance de polarisation du collecteur du sixième transistor ($Q_1$), et d'autre part la première résistance ($R_2$).

7. Amplificateur selon une des revendications précédentes caractérisé en ce que l'étage décaleur de niveau comporte un onzième transistor ($Q''_3$) suiveur en cascade entre le premier ($Q_3$) et le quatrième ($Q'_3$) transistor suiveur, et en ce qu'il comporte un douzième transistor ($Q'_{10}$) formant miroir de courant avec l'élément décaleur de niveau ($Q_4$) et dont le trajet de courant principal est connecté en série entre le trajet de courant principal du onzième transistor ($Q''_3$) et la borne (B) de l'élément décaleur de niveau ($Q_4$) non connectée au quatrième transistor suiveur ($Q'_3$)

8. Amplificateur selon la revendications 7 caractérisé en ce qu'il comporte une première source de courant connectée à la borne (S) commune au quatrième transistor suiveur ($Q'_3$) et à l'élément décaleur de niveau ($Q_4$) et au moins une deuxième source de courant connectée à la base d'au moins un des premier ($Q_3$) et quatrième ($Q'_3$) transistors suiveurs.

9. Amplificateur selon la revendication 8 caractérisé en ce qu'au moins une desdites sources de courant est constituée par une septième résistance ($R_4$, $R_{10}$).

**Patentansprüche**

1. Breitbandverstärker mit einem Direktausgang, an den eine Pegelschiebestufe angeschlossen ist, die wenigstens einen im Pegel verschobenen Ausgang und wenigstens einen ersten reihengeschalteten Emitterfolger mit wenigstens einem Pegelschiebeelement enthält, wobei der erste Transistor einen ersten Widerstand zwischen seiner Basis und einer Speisespannungsquelle und eine negative Rückkopplungsschaltung aus wenigstens einem im Pegel verschobenen Ausgang enthält, <u>dadurch gekennzeichnet</u>, daß

er wenigstens zweite und dritte Transistoren ($Q_{20}$, $Q_{30}$) zur Bildung getrennter Ausgänge enthält, deren Basen mit einem im Pegel verschobenen Ausgang (S) verbunden und derart angeordnet sind, daß ihre Kollektoren getrennte erste bzw. zweite Ausgänge ($S_1$, $S_2$) bilden, daß die Pegelschiebestufe einen vierten Emitterfolger ($Q'_3$) in Kaskadenschaltung zwischen dem Emitterfolger ($Q_3$) und dem Pegelschiebeelement ($Q_4$) enthält, und daß er einen fünften Transistor ($Q_{10}$) zur Bildung einer Stromspiegelschaltung mit dem Pegelschiebeelement ($Q_4$) enthält, und dessen Hauptstromweg in Reihe zwischen dem Hauptstromweg des ersten Emitterfolgers ($Q_3$) und einer Klemme des Pegelschiebeelements ($Q_4$) geschaltet ist, das nicht mit dem vierten Emitterfolger ($Q'_3$) verbunden ist.

2.  Verstärker nach Anspruch 1, dadurch gekennzeichnet, daß das Pegelschiebeelement einen mit Hilfe von Dioden verwirklichten Transistor ist.

3.  Verstärker nach einem der Ansprüche 1 oder 2, dadurch gekennzeichnet, daß der Verstärker einen sechsten Transistor ($Q_1$) enthält, dessen Basis einen Eingang des Verstärkers bildet und dessen Kollektor mit der Basis eines siebten Transistors ($Q_6$) zur Bildung einer Darlington-Stufe mit einem achten Transistor ($Q_2$) stromabwärts in der Schaltung verbunden ist, wobei der Direktausgang (C) mit dem Kollektor des achten Transistors ($Q_2$) verbunden ist, der mit der Basis des ersten Emitterfolgers ($Q_3$) verbunden ist.

4.  Verstärker nach Anspruch 3, dadurch gekennzeichnet, daß die negative Rückkoppelschaltung einen zweiten Widerstand ($R_{F1}$) enthält, der zwischen dem im Pegel verschobenen Ausgang (B) und dem Emitter des sechsten Transistors ($Q_1$) verbunden ist, der einen dritten Emitterwiderstand ($R_{E1}$) enthält.

5.  Verstärker nach einem der Ansprüche 3 oder 4, dadurch gekennzeichnet, daß er einen vierten Widerstand ($R_{F2}$) zwischen dem Emitter des achten Transistors ($Q_2$) und der Basis des sechsten Transistors ($Q_1$) enthalt.

6.  Verstärker nach einem der Ansprüche 3 bis 5, dadurch gekennzeichnet, daß er einen neunten Transistor ($Q_8$) enthält, dessen Basis mit dem im Pegel verschobenen Ausgang (B) verbunden ist und dessen Kollektor über einen fünften Widerstand ($R_8$) mit der Basis eines zehnten Transistors ($Q_7$) verbunden ist, dessen Hauptstromweg zwischen der Speisespannungsquelle und einerseits einem sechsten Vormagnetisierungswiderstand ($R_1$) des Kollektors des sechsten Transistors ($Q_1$) und andererseits dem ersten Widerstand ($R_2$) angeschlossen ist.

7.  Verstärker nach einem oder mehreren der vorangehenden Ansprüche, dadurch gekennzeichnet, daß die Pegelschiebestufe einen elften Emitterfolger ($Q''_3$) in Kaskadenschaltung zwischen den ersten und vierten Emitterfolgern ($Q_3$, $Q'_3$) enthält, und daß er einen zwölften Transistor ($Q'_{10}$) zur Bildung einer Stromspiegelschaltung mit dem Pegelschiebeelement ($Q_4$) enthält, und sein Hauptstromweg in Reihe zwischen dem Hauptstromweg des elften Transistors ($Q''_3$) und der Klemme (B) des Pegelschiebeelements ($Q_4$) angeschlossen ist, das nicht mit dem vierten Emitterfolger ($Q'_3$) verbunden ist.

8.  Verstärker nach Anspruch 7, dadurch gekennzeichnet, daß er eine erste Stromquelle in Verbindung mit der gemeinsamen Klemme (S) des vierten Emitterfolgers ($Q'_3$) und dem Pegelschiebeelement ($Q_4$) und wenigstens eine zweite Stromquelle mit der Basis wenigstens eines der ersten und vierten Emitterfolger ($Q_3$, $Q'_3$) verbunden sind.

9.  Verstärker nach Anspruch 8, dadurch gekennzeichnet, daß wenigstens eine der Stromquellen von einem siebten Widerstand ($R_4$, $R_{10}$) gebildet wird.

## Claims

1.  A wideband amplifier having one direct output to which a level shifting stage is connected, which has at least one level-shifted output and which comprises at least a first follower transistor in series with at least one level shifting element, said transistor having a first resistor arranged between its base and a supply voltage source, and a circuit providing negative feedback from at least one level shifted output, characterised in that it comprises at least second ($Q_{20}$) and a third ($Q_{30}$) transistor forming separate outputs and having their respective bases connected to a said level shifted output (S), which transistors are arranged in such a manner that their collectors form a first ($S_1$) and second ($S_2$) separate output, respectively, in

EP 0 467 450 B1

that the level shifting stage comprises a fourth follower transistor ($Q'_3$) cascaded between the first follower transistor ($Q_3$) and the level shifting element ($Q_4$), and in that it comprises a fifth transistor ($Q_{10}$) forming a current mirror with said level shifting element ($Q_4$) and having its main current path connected in series between the main current path of the first follower transistor ($Q_3$) and a terminal of the level shifting element ($Q_4$), which terminal is not connected to the fourth follower transistor ($Q'_3$).

2.  An amplifier as claimed in Claim 1, characterised in that the level shifting element is a diode-connected transistor.

3.  An amplifier as claimed in Claim 1 or 2, characterised in that it comprises a sixth transistor ($Q_1$) whose base constitutes an input of the amplifier and whose collector is connected to the base of a seventh transistor ($Q_6$) constituting a Darlington stage with a subsequent eighth transistor ($Q_2$), said direct output (C) being provided at the collector of the eighth transistor ($Q_2$), which is connected to the base of the first follower transistor ($Q_3$).

4.  An amplifier as claimed in Claim 3, characterised in that said negative feedback circuit comprises a second resistor ($R_{F1}$) connected between said level-shifted output (B) and the emitter of the sixth transistor ($Q_1$), which has a third emitter resistor ($R_{E1}$).

5.  An amplifier as claimed in Claim 3 or 4, characterised in that it comprises a fourth resistor ($R_{F2}$) connected between the emitter of the eighth transistor ($Q_2$) and the base of the sixth transistor ($Q_1$).

6.  An amplifier as claimed in any one of the Claims 3 to 5, characterised in that it comprises a ninth transistor ($Q_8$), whose base is connected to said level-shifted output (B) and whose collector is connected, through a fifth resistor ($R_8$), to the base of a tenth transistor ($Q_7$), whose main current path is connected between said supply voltage source and, on the one hand, a sixth resistor ($R_1$) for biassing the collector of the sixth transistor ($Q_1$) and, on the other hand, the first resistor ($R_2$).

7.  An amplifier as claimed in any one of the preceding Claims, characterised in that the level shifting stage comprises an eleventh emitter follower ($Q''_3$) cascaded between the first ($Q_3$) and the fourth ($Q'_3$) follower transistor, and in that it comprises a twelfth transistor ($Q'_{10}$) forming a current mirror with the level shifting element ($Q_4$) and having its main current path connected in series between the main current path of the eleventh transistor ($Q''_3$) and the terminal (B) of the level shifting element ($Q_4$) which is not connected to the fourth follower transistor ($Q'_3$).

8.  An amplifier as claimed in Claim 7, characterised in that it comprises a first current source connected to the terminal (S) which is common to the fourth follower transistor ($Q'_3$) and the level shifting element ($Q_4$), and at least a second current source connected to the base of at least one of the first ($Q_3$) and the fourth ($Q'_3$) follower transistor.

9.  An amplifier as claimed in Claim 8, characterised in that at least one of said current sources is constituted by a seventh resistor ($R_4$, $R_{10}$).

7

FIG. 1

FIG. 2

FIG. 3

FIG. 4

FIG. 5